# EUROPEAN PATENT APPLICATION

(11) **EP 4 686 340 A1**
(43) Date of publication of application: **28.01.2026**
(21) Application number: 24212572.2
(22) Date of filing: 13.11.2024
(51) Int. Cl.: H10D 30/01, H10D 30/66, H10D 62/10, H10D 62/17, H10D 64/27, H10D 62/832

(54) **SILICON CARBIDE TRENCH MOSFET AND METHOD OF MANUFACTURING THE SAME**

(30) Priority: 23.07.2024 TW 113127453
(71) Applicant: Hon Hai Precision Industry Co., Ltd., 236 New Taipei City (TW)
(72) Inventor: HUNG, Chia-Lung, 236 New Taipei City (TW); HSIAO, Yi-Kai, 236 New Taipei City (TW); YU, Wei-Cheng, 236 New Taipei City (TW); KUO, Hao-Chung, 236 New Taipei City (TW)
(74) Representative: Becker, Eberhard

(57) **Abstract**

A silicon carbide trench MOSFET includes a substrate (100), an epitaxial layer (102) on the substrate (100), a trench (122, 200, 210, 220, 304), a bottom protection region (128, 306), first and second conductive type heavily-doped regions (106, 108, 310, 308) in the epitaxial layer (102), a sidewall protection region (120, 312), a base region (104, 314), a thick oxide layer (130, 316), a gate oxide layer (132, 318) on inner sidewalls (122s, 304s) of the trench (122, 200, 210, 220, 304), separated gates (134, 320) on the gate oxide layer (132, 318) in the trench (122, 200, 210, 220, 304), and an insulating material layer (136, 322) covering the gates (134, 320) in the trench (122, 200, 210, 220, 304). A bottom (122b, 200b, 210b, 220b, 304b) of the trench (122, 200, 210, 220, 304) has rounded corners (CR). The bottom protection region (128, 306) is below the bottom (122b, 200b, 210b, 220b, 304b) of the trench (122, 200, 210, 220, 304). The first and second conductive type heavily-doped regions (106, 108, 310, 308) are in the surface (102s, 302s) of the epitaxial layer (102) and on both sides of the trench (122, 200, 210, 220, 304). The sidewall protection region (120, 312) is located below the second conductive type heavily-doped region (108, 310) in the epitaxial layer (102). The thick oxide layer (130, 316) is disposed at the bottom (122b, 200b, 210b, 220b, 304b) of the trench (122, 200, 210, 220, 304).

## Description

### BACKGROUND

### Technical Field

The disclosure relates to a trench metal oxide semiconductor field effect transistor (trench MOSFET), and more particularly, to a silicon carbide trench MOSFET and a method of manufacturing the same.

### Description of Related Art

In a field of silicon carbide power components, how to reduce on-resistance to increase power density is a development direction of the industry and academia.

Therefore, compared to existing planar transistors, trench transistors with lower on-resistance have become a focus of research and development of power components.

However, transistors with trench architectures will encounter high electric field effects at a bottom of a trench, which will lead to early breakdown of components and degradation of reliability.

### SUMMARY

The disclosure provides a method of manufacturing a silicon carbide trench MOSFET, which may be manufactured in a manner of self-alignment.

The disclosure provides a silicon carbide trench type MOSFET, which may reduce on-resistance and improve reliability of a component.

A method of manufacturing a silicon carbide trench MOSFET in the disclosure includes the following. A substrate is provided, and an epitaxial layer is formed on a surface of the substrate. A base region is formed in the epitaxial layer, and a first conductive type heavily-doped region and a second conductive type heavily-doped region are formed in a staggered arrangement on a surface of the epitaxial layer in the base region. Then, a first hardmask structure is formed on the surface of the epitaxial layer to cover the first conductive type heavily-doped region and expose the second conductive type heavily-doped region. Using the first hardmask structure as a mask, multiple ion implantation is performed to form a sidewall protection region below the second conductive type heavily-doped region in the epitaxial layer. After that, the first hardmask structure is removed. A second hardmask structure is formed on the surface of the epitaxial layer, and a portion of the first conductive type heavily-doped region where a trench is intended to be formed is exposed. Using the second hardmask structure as a mask, the epitaxial layer is etched to form a trench passing through the first conductive type heavily-doped region and the base region, and then rounding processing is performed on the trench, so that a bottom of the trench has a rounded corner. The second hardmask structure is removed. A spacer is formed on an inner sidewall of the trench, and a portion of the bottom of the trench is exposed. Another ion implantation is performed to form a bottom protection region below the bottom of the trench, and then the spacer is removed to expose the entire inner sidewall and bottom of the trench. A thick oxide layer is formed on the bottom of the trench, and a gate oxide layer is formed on the inner sidewall of the trench. Multiple separated gates are formed on the inner sidewall of the trench. An insulating material layer is filled in the trench.

A silicon carbide trench MOSFET in the disclosure includes a substrate, an epitaxial layer, a trench, a bottom protection region, a first conductive type heavily-doped region, a second conductive type heavily-doped region, a sidewall protection region, a base region, a thick oxide layer, a gate oxide layer, multiple separated gates, and an insulating material layer. The epitaxial layer is disposed on the substrate. The trench extends from a surface of the epitaxial layer towards the substrate. A bottom of the trench has a rounded corner. A bottom protection region is located below the bottom of the trench. A first conductive type heavily-doped region is located on the surface of the epitaxial layer and on both sides of the trench. A second conductive type heavily-doped region is also located on the surface of the epitaxial layer and on a side of the first conductive type heavily-doped region away from the trench. A sidewall protection region is located below the second conductive type heavily-doped region in the epitaxial layer. A depth of the sidewall protection region is greater than a depth of the trench. A base region is located between the sidewall protection region and the trench. A thick oxide layer is disposed on the bottom of the trench. A gate oxide layer is disposed on an inner sidewall of the trench. The separated gates are disposed on the inner sidewall of the trench. An insulating material layer is disposed in the trench and covering the gates.

Another silicon carbide trench MOSFET in the disclosure includes a substrate, an epitaxial layer, a trench, a bottom protection region, a first conductive type heavily-doped region, a second conductive type heavily-doped region, a sidewall protection region, a base region, a thick oxide layer, a gate oxide layer, multiple separated gates, and an insulating material layer. The epitaxial layer is disposed on the substrate. The trench extends from a surface of the epitaxial layer towards the substrate. A bottom of the trench has a rounded corner. The bottom protection region is located below the bottom of the trench. The bottom protection region has a profile that is wide at a top and narrow at a bottom, and a doping concentration of the bottom protection region gradually becomes lighter from a top center outward. The first conductive type heavily-doped region is located on the surface of the epitaxial layer and on both sides of the trench. The second conductive type heavily-doped region is also located on the surface of the epitaxial layer and on a side of the first conductive type heavily-doped region away from the trench. The sidewall protection region is located below the second conductive type heavily-doped region in the epitaxial layer. The base region is located between the sidewall protection region and the trench. The thick oxide layer is disposed on the bottom of the trench. The gate oxide layer is disposed on an inner sidewall of the trench. The separated gates are disposed on the inner sidewall of the trench. The insulating material layer is disposed in the trench and covering the gates.

Based on the above, in the disclosure, a self-alignment method is used to respectively form the protection regions on the sidewall of the trench and the bottom of the silicon carbide trench MOSFET to reduce the electric field intensity and improve reliability of a component without worrying about degradation of component performance caused by alignment errors.

In order for the aforementioned features and advantages of the disclosure to be more comprehensible, embodiments accompanied with drawings are described in detail below.

### BRIEF DESCRIPTION OF THE DRAWINGS

FIGs. 1A to 1K are schematic cross-sectional diagrams of a manufacturing process of a silicon carbide trench MOSFET according to the first embodiment of the disclosure.
FIG. 2A is a schematic cross-sectional diagram of an example of a bottom of a trench in the silicon carbide trench MOSFET in the first embodiment.
FIG. 2B is a schematic cross-sectional diagram of another example of the bottom of the trench in the silicon carbide trench MOSFET in the first embodiment.
FIG. 2C is a schematic cross-sectional diagram of still another example of the bottom of the trench in the silicon carbide trench MOSFET in the first embodiment.
FIG. 3 is a schematic cross-sectional diagram of a silicon carbide trench MOSFET according to the second embodiment of the disclosure.
FIGs. 4A and 4B are distribution diagrams of an electric field of a silicon carbide trench MOSFET of a simulation object 1 and a simulation object 2 respectively.
FIGs. 5A and 5B are distribution diagrams of current density of a silicon carbide trench MOSFET of a simulation object 1 and a simulation object 2 respectively.

### DETAILED DESCRIPTION OF DISCLOSED EMBODIMENTS

The embodiments are described in detail below with reference to the accompanying drawings, but the provided embodiments are not intended to limit the scope of the disclosure. In addition, for convenience of description, a size of a region or film layer in the drawing is not an actual scale.

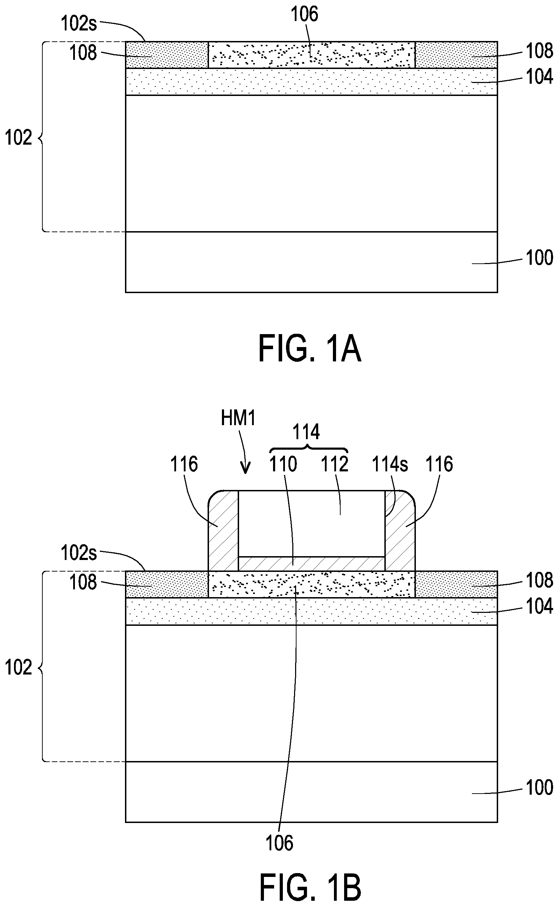

FIGs. 1A to 1K are schematic cross-sectional diagrams of a manufacturing process of a silicon carbide trench MOSFET according to the first embodiment of the disclosure.

Referring to FIG. 1A, a substrate 100 is provided, and an epitaxial layer 102 is formed on a surface of the substrate 100. The substrate 100 is, for example, an N-type silicon carbide substrate, and the epitaxial layer 102 is, for example, an N-type epitaxial layer. A base region 104 is formed in the epitaxial layer 102. The base region 104 is, for example, a p-base region, and a method of forming the base region 104 is, for example, an ion implantation process. In the base region 104, a first conductive type heavily-doped region 106 and a second conductive type heavily-doped region 108 are formed on a surface 102s of the epitaxial layer 102 in a staggered arrangement. A method of forming the first conductive type heavily-doped region 106 and the second conductive type heavily-doped region 108 is, for example, the ion implantation process. In this embodiment, the first conductive type heavily-doped region 106, such as an N+ region, serves as a source region of the subsequently formed silicon carbide trench MOSFET, and the second conductive type heavily-doped region 108, such as a P+ region, may be used to stabilize a potential.

Next, referring to FIG. 1B, a first hardmask structure HM1 is formed on the surface 102s of the epitaxial layer 102 to cover the first conductive type heavily-doped region 106 and expose the second conductive type heavily-doped region 108. A method of forming the first hardmask structure HM1 includes first forming a polysilicon layer 110 on the surface 102s, forming a silicon oxide layer 112 on the polysilicon layer 110, then patterning the polysilicon layer 110 and the silicon oxide layer 112 to form a stacked structure 114 covering the first conductivity type heavily-doped region 106, and forming a polysilicon spacer 116 on a sidewall 114s of the stacked structure 114. Since the first hardmask structure HM1 is manufactured using a self-alignment technology, it may prevent degradation of component performance caused by alignment errors.

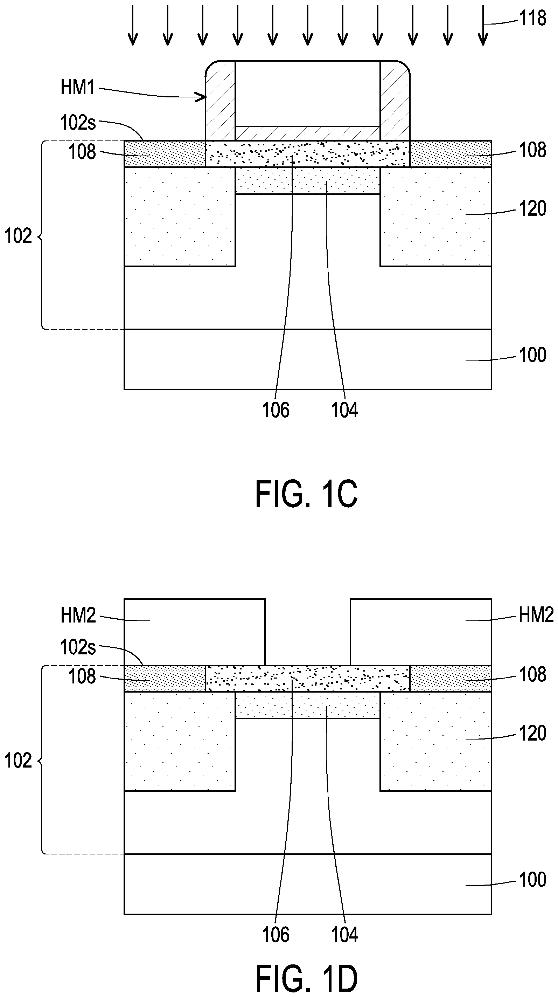

Then, referring to FIG. 1C, using the first hardmask structure HM1 as a mask, multiple ion implantation 118 is performed to form a sidewall protection region 120 below the second conductive type heavily-doped region 108 in the epitaxial layer 102. The sidewall protection region 120 is for example a P-type region. Since in the multiple ion implantation 118, a doping concentration and a doping dose at each of phases may be adjusted, the sidewall protection region 120 may have a doping concentration that gradually becomes lighter from the surface 102s downward. In addition, the sidewall protection region 120 may extend below two sides of the first conductive type heavily-doped region 106 due to a lateral collision component caused by the ion implantation.

Next, referring to FIG. 1D, after the first hardmask structure HM1 in FIG. 1C is removed, a second hardmask structure HM2 is formed on the surface 102s of the epitaxial layer 102, and a portion of the first conductive type heavily-doped region 106 where a trench is intended to be formed is exposed. A method of forming the second hardmask structure HM2 is, for example, but not limited to, first depositing a layer of a hardmask material comprehensively on the surface 102s of the epitaxial layer 102, and then performing patterning by using a photomask process, so as to obtain the second hardmask structure HM2 covering a portion of the surface 102s of the epitaxial layer 102.

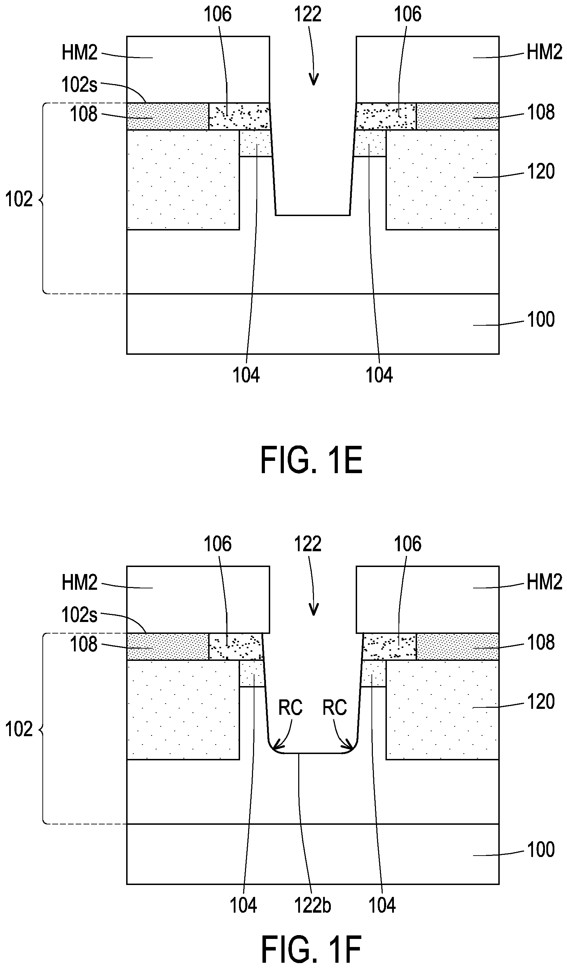

Then, referring to FIG. 1E, using the second hardmask structure HM2 as a mask, the epitaxial layer 102 is etched to form a trench 122 that passes through the first conductive type heavily-doped region 106 and the base region 104. A depth of the trench is required to be between a bottom of the base region 104 and a bottom of the sidewall protection region 120 in order to completely form a sidewall channel region and allow a sidewall protection structure (i.e., the first conductive type heavily-doped region 106) to effectively protect the entire trench 122.

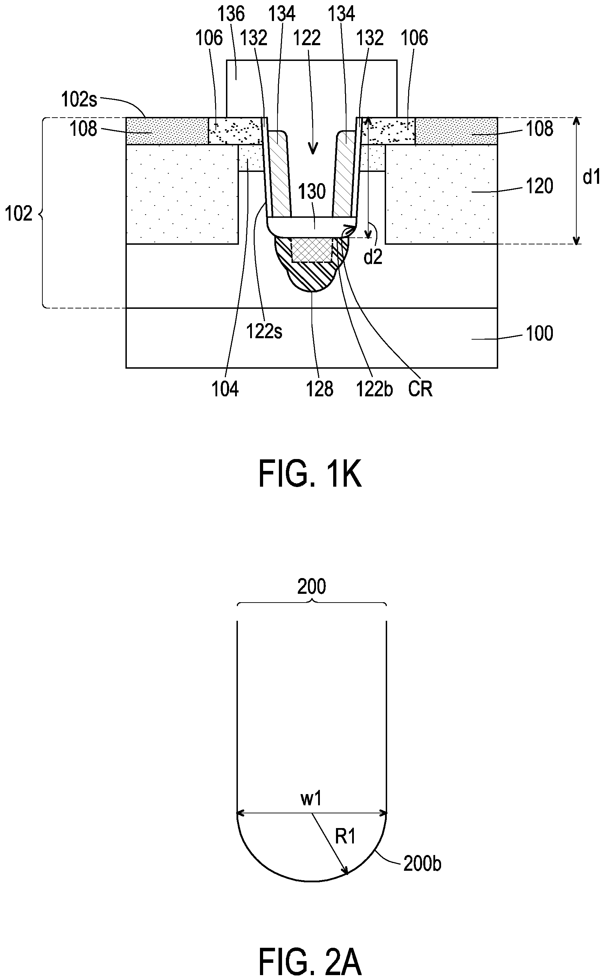

Then, referring to FIG. 1F, rounding processing is performed on the trench 122, so that a bottom 122b of the trench 122 has a rounded corner CR. Since in the above rounding processing, a portion of the trench 122 is removed, the trench 122 after the rounding is larger and deeper than the trench 122 after direct etching (FIG. 1E). A width of the entire trench may not exceed a boundary of the base region 104 and the sidewall protection region 120, and the depth of the trench may not exceed the bottom of the sidewall protection region 120. In this embodiment, the bottom 122b of the trench 122 is partial rounding, but the disclosure is not limited thereto. In other embodiments, the bottom 122b of the trench 122 may be full rounding. A detailed structure will be described later in FIGs. 2A to 2C.

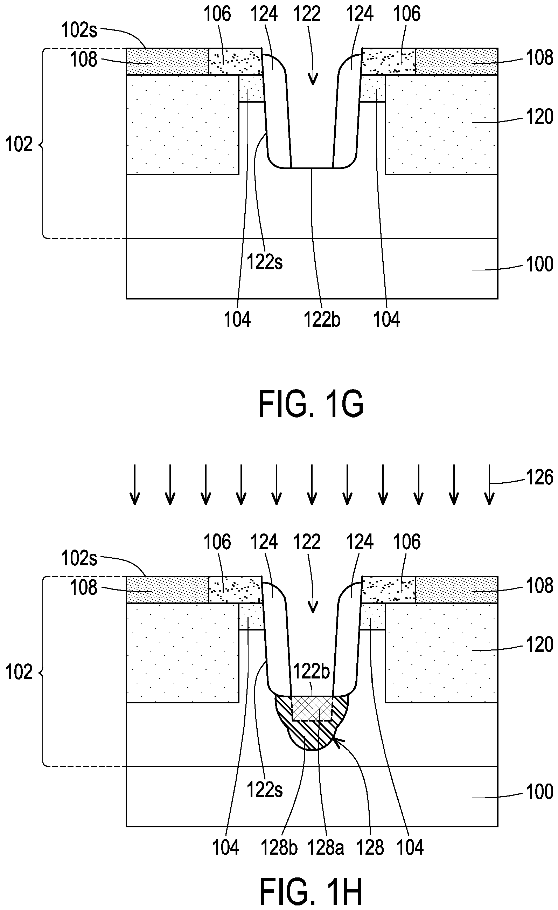

Subsequently, referring to FIG. 1G, after the second hardmask structure HM2 in FIG. 1F is removed, a spacer 124 is formed on an inner sidewall 122s of the trench 122, and a portion of the bottom 122b of the trench 122 is exposed. A method of forming the spacer 124 is to, for example, but not limited to, first form a spacing material layer conformally on the surface 102s of the epitaxial layer 102, cover the surface 102s, the inner sidewall 122s and the bottom 122b of the trench 122, and then anisotropic etching is performed on the spacing material layer until the bottom 122b is exposed. A width of the spacer 124 itself is required to be no less than a threshold value (0.2 µm to 0.4 µm), so that a lateral extension range of ion implantation of a subsequently formed bottom protection region (a bottom protection region 128b in FIG. 1H) may not exceed the sidewall of the trench 122 in order to prevent the bottom protection region from being unable to effectively protect a corner of the trench (i.e., the rounded corner CR in FIG. 1F).

Next, referring to FIG. 1H, ion implantation 126 is performed to form the bottom protection region 128 below the bottom 122b of the trench 122, and the bottom protection region 128 is, for example, a P-type region. Due to the existence of the spacer 124, dopants implanted in the epitaxial layer 102 of the bottom 122b of the trench 122 during the ion implantation 126 is concentrated in a top center of the bottom protection region 128. Therefore, a doping concentration of the bottom protection region 128 gradually becomes lighter from the top center outward, so a doping concentration of a first region 128a of the bottom protection region 128 is higher than a doping concentration of a second region 128b. In addition, an edge of the bottom protection region 128 does not extend beyond two sides of the inner sidewall 122s of the trench 122, thus preventing a current from being blocked by the bottom protection region 128.

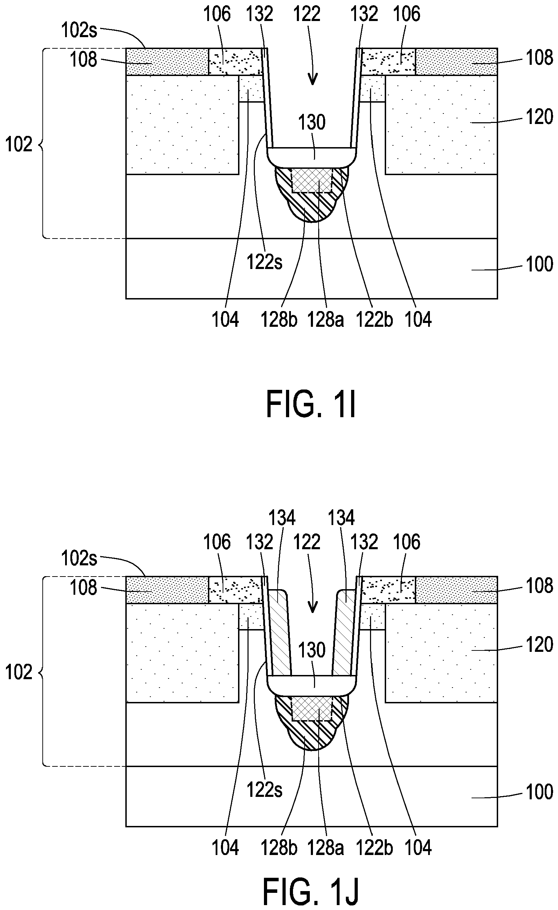

Then, referring to FIG. 1I, after the spacer 124 in FIG. 1H is removed, the entire inner sidewall 122s and bottom 122b of the trench are exposed. A thick oxide layer 130 is formed on the bottom 122b of the trench 122. A gate oxide layer 132 is formed on the inner sidewall 122s of the trench 122. A method of forming the thick oxide layer 130 is to, for example, but not limited to, first perform a deposition process and then etching back to form the thick oxide layer 130. The "thick" oxide layer herein refers to an oxide layer that is thicker than the gate oxide layer 132, and CVD or other suitable deposition processes may be used to form the thick oxide layer 130 with good quality.

Next, referring to FIG. 1J, multiple separated gates 134 are formed on the inner sidewall 122s of the trench 122. A top of the gate 134 may not exceed the surface 102s and may not be lower than a bottom of the first conductive type heavily-doped region 106 in order to prevent issues that the gate and the source are connected together to cause a short circuit and that the entire sidewall channel region may not be effectively controlled by the gate, resulting in an open circuit. A method of forming the separated gates 134 is to, for example, but not limited to, conformally form a conductive material layer, cover the gate oxide layer 132 and the thick oxide layer 130, and then perform the anisotropic etching on the conductive material layer until the thick oxide layer 130 is exposed. The separated gates 134 may reduce the Miller capacitance, thereby increasing a switching speed of a component.

After that, referring to FIG. 1K, an insulating material layer 136 is filled in the trench 122. A method of forming the insulating material layer 136 is to, for example, but not limited to, deposit or coat an insulating material filling the trench 122 on the surface 102s of the epitaxial layer 102, and then performing a patterning process, so as to expose the second conductive type heavily-doped region 108 and a portion of the first conductive type heavily-doped region 106. Subsequently, a conductive layer may be formed on the insulating material layer 136 as a source electrode (not shown) in contact with the first conductive type heavily-doped region 106 and the second conductive type heavily-doped region 108.

In FIG. 1K, the silicon carbide trench MOSFET includes the substrate 100, the epitaxial layer 102, the trench 122, the bottom protection region 128, the first conductive type heavily-doped region 106, the second conductive type heavily-doped region 108, the sidewall protection region 120, the base region 104, thick oxide layer 130, the gate oxide layer 132, the separated gates 134, and the insulating material layer 136. The epitaxial layer 102 is disposed on the substrate 100. The epitaxial layer 102 is, for example, the N-type epitaxial layer. In some embodiments, a thickness of the epitaxial layer 102 is, for example, 5 µm to 100 µm, and a doping concentration of the epitaxial layer 102 is, for example, 1E15 cm⁻³ to 6E16 cm⁻³. Unless otherwise noted, the "thickness" herein generally refers to a thickness in a vertical direction. The base region 104 is, for example, the P-type base region. In some embodiments, a thickness of the base region 104 is, for example, 0.3 µm to 1 µm, and a doping concentration of the base region 104 is, for example, 5E16 cm⁻³ to 1E19 cm⁻³. The trench 122 extends inwardly from the surface 102s of the epitaxial layer 102. The bottom 122b of the trench 122 has the rounded corner CR to reduce concentration of an electric field here. In some embodiments, the rounded corner CR may have a radius of curvature of 0.3 µm to 1.5 µm. The bottom protection region 128 is formed below the bottom 122b of the trench 122. The bottom protection region 128, such as the P-type region, may reduce the electric field intensity through space charges. The doping concentration of the bottom protection region 128 may gradually become lighter from the top center outward. In some embodiments, a thickness of the bottom protection region 128 is, for example, 0.3 µm to 0.8 µm, and the doping concentration of the bottom protection region 128 is, for example, in a range of 5E16 to 1E19 cm⁻³. The first conductive type heavily-doped region 106 is formed on the surface 102s of the epitaxial layer 102 and is located on both sides of the trench 122. The second conductive type heavily-doped region 108 is also formed on the surface 102s of the epitaxial layer 102 and is located outside the first conductive type heavily-doped region 106. The first conductive type heavily-doped region 106 is, for example, the N+ region, and the second conductive type heavily-doped region 108 is, for example, the P+ region. In some embodiments, a thickness of the first conductive type heavily-doped region 106 is, for example, 0.3 µm to 0.6 µm, and a doping concentration of the first conductive type heavily-doped region 106 is, for example, 1E19 cm⁻³ to 1E21 cm⁻³. In some embodiments, a thickness of the second conductive type heavily-doped region 108 is, for example, 0.3 µm to 0.6 µm, and a doping concentration of the second conductive type heavily-doped region 108 is, for example, 1E19 cm⁻³ to 1E21 cm⁻³.

Continuing to refer to FIG. 1K, the sidewall protection region 120 is located below the second conductive type heavily-doped region 108 in the epitaxial layer 102, and may extend below the first conductive type heavily-doped region 106, so as to protect the thinner gate oxide layer 132 in the trench 122. The sidewall protection region 120 is, for example, the P-type region. In some embodiments, a thickness of the sidewall protection region 120 is, for example, 1 µm to 2.0 µm, and a doping concentration of the sidewall protection region 120 is, for example, in the range of 5E16 to 1E19 cm⁻³. In this embodiment, a depth d1 of the sidewall protection region 120 is greater than a depth d2 of the trench 122, which may effectively reduce the electric field on the side of the trench 122 and prevent early breakdown of the component. The "depth" herein refers to a vertical distance from the surface 102s to a bottom of a feature. In other embodiments, the depth d1 of the sidewall protection region 120 may be equal to the depth d2. The base region 104 is located between the sidewall protection region 120 and the trench 122. In some embodiments, the thickness of the base region 104 is, for example, 0.3 µm to 1 µm, and the doping concentration of the base region 104 is, for example, 5E16 cm⁻³ to 1E19 cm⁻³. The thick oxide layer 130 is disposed at the bottom 122b of the trench 122 to help reduce the electric field intensity. In some embodiments, a thickness of the thick oxide layer 130 is, for example, 0.2 µm to 0.4 µm. The gate oxide layer 132 is disposed on the inner sidewall 122s of the trench 122. In some embodiments, a (horizontal) thickness of the gate oxide layer 132 is, for example, 0.02 µm to 0.1 µm. The separated gates 134 are disposed on the inner sidewall 122s of the trench 122. In some embodiments, a (horizontal) thickness of the gate 134 is, for example, 0.4 µm to 1.2 µm. The insulating material layer 136 is disposed in the trench 122 and covers the gates 134. In some embodiments, a thickness of the insulating material layer 136 is, for example, 0.8 µm to 1.5 µm.

The above numerical ranges are ranges used in some embodiments, but the disclosure is not limited to the above ranges.

FIG. 2A is a schematic cross-sectional diagram of an example of a bottom of a trench in the silicon carbide trench MOSFET in the first embodiment. In FIG. 2A , a bottom 200b of a trench 200 is full rounding. If a width w1 of the trench 200 is about 1 µm, a radius of curvature R1 of the rounded corner is, for example, in a range of 0.3 µm to 0.5 µm.

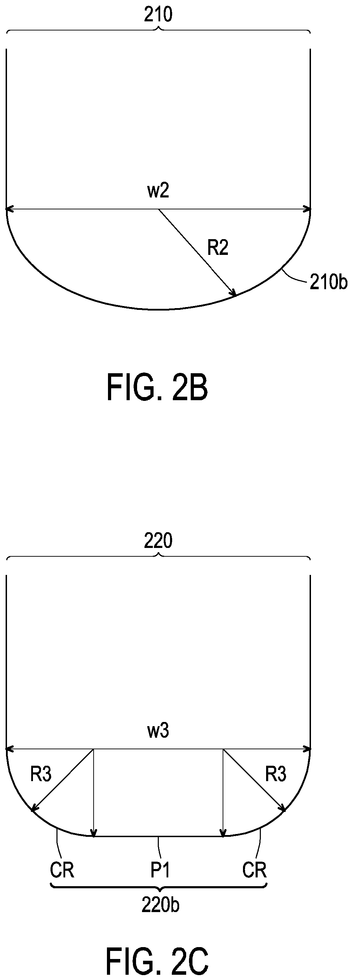

FIG. 2B is a schematic cross-sectional diagram of another example of the bottom of the trench in the silicon carbide trench MOSFET in the first embodiment. If a width w2 of a trench 210 is about 2 µm, a radius of curvature R2 of the rounded corner is, for example, in a range of 0.6 µm to 1 µm.

FIG. 2C is a schematic cross-sectional diagram of still another example of the bottom of the trench in the silicon carbide trench MOSFET in the first embodiment. In FIG. 2C , a bottom 220b of a trench 220 is partial rounding, which includes the rounded corners CR on both sides and a plane P1 in the middle. If a width w3 of the trench 220 is about 2 µm, a radius of curvature R3 of the rounded corner CR is, for example, in the range of 0.3 µm to 0.5 µm.

If the radius of curvature of the bottom of the trench is in the above ranges, it may reduce the concentration of the electric field at the corner of the bottom of the trench.

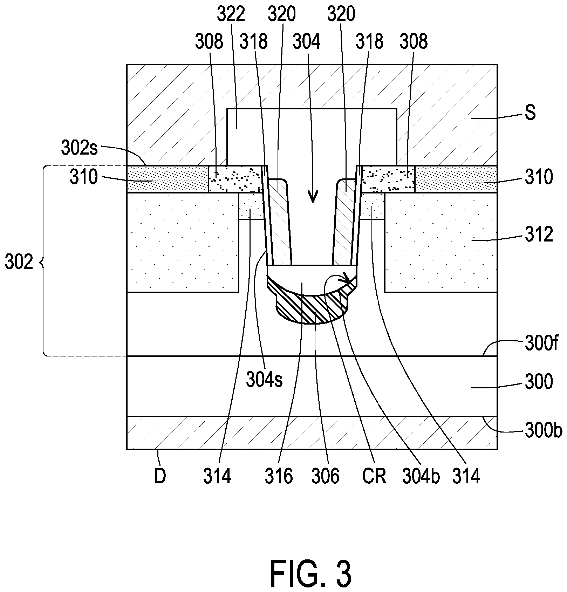

FIG. 3 is a schematic cross-sectional diagram of a silicon carbide trench MOSFET according to the second embodiment of the disclosure.

Referring to FIG. 3, the silicon carbide trench MOSFET in the second embodiment includes a substrate 300, an epitaxial layer 302, a trench 304, a bottom protection region 306, a first conductive type heavily-doped region 308, a second conductive type heavily-doped region 310, a sidewall protection region 312, a base region 314, a thick oxide layer 316, a gate oxide layer 318, multiple separated gates 320, and an insulating material layer 322. The epitaxial layer 302 is disposed on a front side 300f of the substrate 300. Both the substrate 300 and the epitaxial layer 302 are N-type. In some embodiments, a thickness of the epitaxial layer 302 is, for example, 5 µm to 100 µm, and a doping concentration of the epitaxial layer 302 is, for example, 1E15 cm⁻³ to 6E16 cm⁻³. The trench 304 extends from a surface 302s of the epitaxial layer 302 towards the substrate 300. A bottom 304b of the trench 304 has the rounded corner CR. In some embodiments, the rounded corner CR may have the radius of curvature of 0.3 µm to 1.5 µm. The bottom 304b of the trench 304 in the second embodiment is full rounding, and the radius of curvature of the rounded corner CR may be in the range of 0.3 µm to 0.5 µm or in the range of 0.6 µm to 1 µm. However, the disclosure is not limited thereto. In other embodiments, the bottom 304b of the trench 304 may be partial rounding and have a radius of curvature of 0.3 µm to 0.5 µm. The bottom protection region 306 is located below the bottom 304b of the trench 304. The bottom protection region 306 is a P-type region. The bottom protection region 306 has a profile that is wide at the top and narrow at the bottom. From the cross-sectional diagram, the bottom protection region 306 does not exceed two sides of an inner sidewall 304s of the trench 304, so it may prevent the current from being blocked by the bottom protection region 306 (and the sidewall protection region 312). In an embodiment, a doping concentration of the bottom protection region 306 may gradually become lighter from the top center outward. In some embodiments, a thickness of the bottom protection region 306 is, for example, 0.3 µm to 0.8 µm, and the doping concentration of the bottom protection region 306 is, for example, in the range of 5E16 to 1E19 cm⁻³.

Continuing to refer to FIG. 3, the first conductive type heavily-doped region 308 is located on the surface 302s of the epitaxial layer 302 and on both sides of the trench 304. The second conductive type heavily-doped region 310 is located on the surface 302s of the epitaxial layer 302 and is located on a side of the first conductive type heavily-doped region 308 away from the trench 304. The first conductive type heavily-doped region 308 is an N+ region, and the second conductive type heavily-doped region 310 is a P+ region. In some embodiments, a thickness of the first conductive type heavily-doped region 308 is, for example, 0.3 µm to 0.6 µm, and a doping concentration of the first conductive type heavily-doped region 308 is, for example, 1E19 cm⁻³ to 1E21 cm⁻³. In some embodiments, a thickness of the second conductive type heavily-doped region 310 is, for example, 0.3 µm to 0.6 µm, and a doping concentration of the second conductive type heavily-doped region 310 is, for example, 1E19 cm⁻³ to 1E21 cm⁻³. The sidewall protection region 312 is located below the second conductive type heavily-doped region 310 in the epitaxial layer 302. The sidewall protection region 312 is a P-type region, and may have a doping concentration that gradually becomes lighter from the surface downward. In some embodiments, a thickness of the sidewall protection region 312 is, for example, 1 µm to 2 µm, and the doping concentration of the sidewall protection region 312 is, for example, in the range of 5E16 to 1E19 cm⁻³. The base region 314 is P-type. The base region 314 is located between the sidewall protection region 312 and the trench 304. In some embodiments, a thickness of the base region 314 is, for example, 0.3 µm to 1 µm, and a doping concentration of the base region 314 is, for example, 5E16 cm⁻³ to 1E19 cm⁻³. The thick oxide layer 316 is disposed on the bottom 304b of the trench 304. In some embodiments, a thickness of the thick oxide layer 316 is, for example, 0.2 µm to 0.4 µm. The gate oxide layer 318 is disposed on the inner sidewall 304s of the trench 304. In some embodiments, a (horizontal) thickness of the gate oxide layer 318 is, for example, 0.02 µm to 0.1 µm. The separated gates 320 are disposed on the inner sidewall 304s of the trench 304. In some embodiments, a (horizontal) thickness of the gate 320 is, for example, 0.4 µm to 1.2 µm. The insulating material layer 322 is disposed in the trench 304 and covers the gates 320. In some embodiments, a thickness of the insulating material layer 322 is, for example, 0.8 µm to 1.5 µm. A source electrode S may be formed on the insulating material layer 322 and be in direct contact with the first conductive type heavily-doped region 308 and the second conductive type heavily-doped region 310. A back 300b of the substrate 300 may be provided with a drain electrode D.

The above numerical ranges are ranges used in some embodiments, but the disclosure is not limited to the above ranges.

In order to verify the efficacy of the disclosure, the following simulation experiments are provided, but it should be noted that the results are not used to limit the scope of application in the disclosure.

First, a simulation object 1 is a control silicon carbide trench MOSFET, which has no thick oxide layer, sidewall protection region, and bottom protection region, and the bottom of the trench has no rounded corners. A simulation object 2 is a silicon carbide trench MOSFET in the disclosure, which has the thick oxide layer, the sidewall protection region, and the bottom protection region, and the bottom of the trench has the rounded corners. Other structures (e.g., the first conductive type heavily-doped region, the second conductive type heavily-doped region, the gate oxide layer, the base region, etc.) in the simulation objects 1 and 2 are the same. Simulation conditions are all in an operating environment of 1700V.

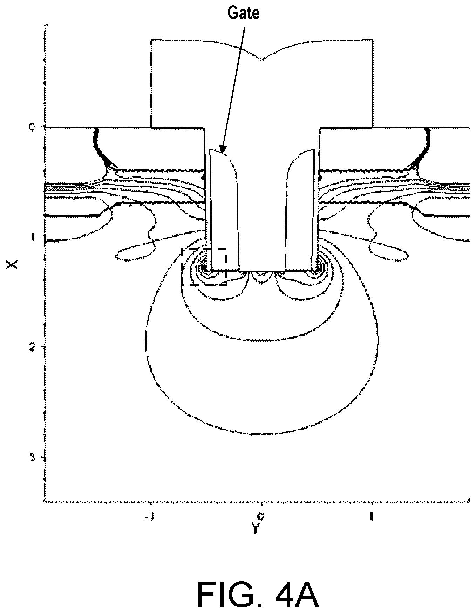

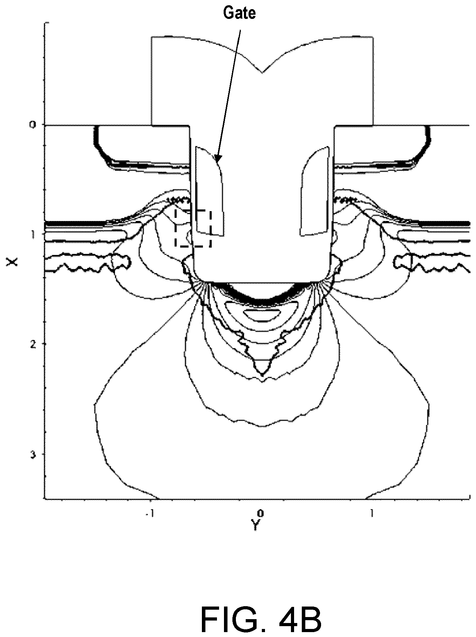

FIGs. 4A and 4B are distribution diagrams of an electric field of a silicon carbide trench MOSFET of a simulation object 1 and a simulation object 2 respectively.

In FIGs. 4A and 4B, a square dashed frame is used to mark a trench position near a bottom of the gate. There are obviously dense power lines at the bottom of the gate in FIG. 4A, while there are no dense power lines at the bottom of the gate in FIG. 4B. Therefore, it may be seen that the silicon carbide trench MOSFET in the disclosure indeed has an effect of reducing the electric field intensity.

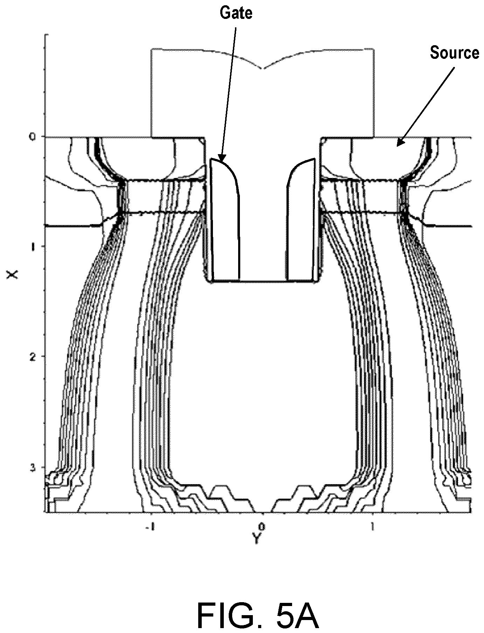

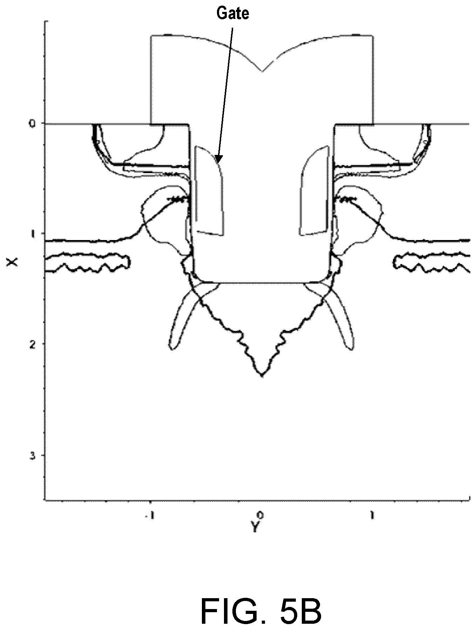

FIGs. 5A and 5B are distribution diagrams of current density of a silicon carbide trench MOSFET of a simulation object 1 and a simulation object 2 respectively.

In FIG. 5A, there are obvious current lines running from the source to the bottom (drain) of the component, while in FIG. 5B, there is no current flowing to the bottom of the component. Therefore, it may be seen that the silicon carbide trench MOSFET in the disclosure has an effect of preventing the early breakdown of the component.

## Claims

1. A method of manufacturing a silicon carbide trench MOSFET, comprising:
providing a substrate (100), and forming an epitaxial layer (102) on a surface of the substrate (100);
forming a base region (104, 314) in the epitaxial layer (102);
forming a first conductive type heavily-doped region (106, 308) and a second conductive type heavily-doped region (108, 310) in a staggered arrangement on a surface (102s, 302s) of the epitaxial layer (102) in the base region (104, 314);
forming a first hardmask structure (HM1) on the surface (102s, 302s) of the epitaxial layer (102) to cover the first conductive type heavily-doped region (106, 308) and expose the second conductive type heavily-doped region (108, 310);
using the first hardmask structure (HM1) as a mask, performing multiple ion implantation (118) to form a sidewall protection region (120, 312) below the second conductive type heavily-doped region (108, 310) in the epitaxial layer (102);
removing the first hardmask structure (HM1);
forming a second hardmask structure (HM2) on the surface (102s, 302s) of the epitaxial layer (102), and expose a portion of the first conductive type heavily-doped region (106, 308) where a trench (122, 200, 210, 220, 304) is intended to be formed;
using the second hardmask structure (HM2) as a mask, etching the epitaxial layer (102) to form a trench (122, 200, 210, 220, 304) passing through the first conductive type heavily-doped region (106, 308) and the base region (104, 314);
performing rounding processing on the trench (122, 200, 210, 220, 304) such that a bottom (122b, 200b, 210b, 220b, 304b) of the trench (122, 200, 210, 220, 304) has a rounded corner (CR);
removing the second hardmask structure (HM2);
forming a spacer (124) on an inner sidewall (122s, 304s) of the trench (122, 200, 210, 220, 304), and expose a portion of the bottom (122b, 200b, 210b, 220b, 304b) of the trench (122, 200, 210, 220, 304);
performing ion implantation (126) to form a bottom protection region (128, 306) below the bottom (122b, 200b, 210b, 220b, 304b) of the trench (122, 200, 210, 220, 304);
removing the spacer (124) to expose the entire inner sidewall (122s, 304s) and bottom (122b, 200b, 210b, 220b, 304b) of the trench (122, 200, 210, 220, 304);
forming a thick oxide layer (130, 316) on the bottom (122b, 200b, 210b, 220b, 304b) of the trench (122, 200, 210, 220, 304);
forming a gate oxide layer (132, 318) on the inner sidewall (122s, 304s) of the trench (122, 200, 210, 220, 304);
forming a plurality of separated gates (134, 320) on the inner sidewall (122s, 304s) of the trench (122, 200, 210, 220, 304); and
filling an insulating material layer (136, 322) in the trench (122, 200, 210, 220, 304).

2. The method of manufacturing the silicon carbide trench MOSFET according to claim 1, wherein the epitaxial layer (102) is an N-type epitaxial layer, and the base region (104, 314) is a P-type base region.

3. The method of manufacturing the silicon carbide trench MOSFET according to claim 2, wherein the first conductive type heavily-doped region (106, 308) is an N+ region, and the second conductive type heavily-doped region (108, 310) is a P+ region.

4. The method of manufacturing the silicon carbide trench MOSFET according to claim 2, wherein the sidewall protection region (120, 312) is a P-type region, and the bottom protection region (128, 306) is a P-type region.

5. The method of manufacturing the silicon carbide trench MOSFET according to claim 1, wherein a method of forming the first hardmask structure (HM1) comprises:
forming a polysilicon layer (110) on the surface (102s, 302s);
forming a silicon oxide layer (112) on the polysilicon layer (110);
patterning the polysilicon layer (110) and the silicon oxide layer (112) to form a stacked structure (114) covering the first conductive type heavily-doped region (106, 308); and
forming a polysilicon spacer (116) on a sidewall (114s) of the stacked structure (114).

6. The method of manufacturing the silicon carbide trench MOSFET according to claim 1, wherein the bottom (122b, 200b, 210b, 220b, 304b) of the trench (122, 200, 210, 220, 304) is full rounding or partial rounding.

7. The method of manufacturing the silicon carbide trench MOSFET according to claim 1, wherein a method of forming the separated gates (134, 320) comprises:
conformally forming a conductive material layer, covering the gate oxide layer (132, 318) and the thick oxide layer (130, 316); and
performing anisotropic etching on the conductive material layer until the thick oxide layer (130, 316) is exposed.

8. A silicon carbide trench MOSFET, comprising:
a substrate (100);
an epitaxial layer (102) disposed on the substrate (100);
a trench (122, 200, 210, 220, 304) extending from a surface (102s, 302s) of the epitaxial layer (102) towards the substrate (100), wherein a bottom (122b, 200b, 210b, 220b, 304b) of the trench (122, 200, 210, 220, 304) has a rounded corner (CR);
a bottom protection region (128, 306) located below the bottom (122b, 200b, 210b, 220b, 304b) of the trench (122, 200, 210, 220, 304);
a first conductive type heavily-doped region (106, 308) located on the surface (102s, 302s) of the epitaxial layer (102) and on both sides of the trench (122, 200, 210, 220, 304);
a second conductive type heavily-doped region (108, 310) located on the surface (102s, 302s) of the epitaxial layer (102) and on a side of the first conductive type heavily-doped region (106, 308) away from the trench (122, 200, 210, 220, 304);
a sidewall protection region (120, 312) located below the second conductive type heavily-doped region (108, 310) in the epitaxial layer (102), wherein a depth (d1, d2) of the sidewall protection region (120, 312) is greater than a depth (d1, d2) of the trench (122, 200, 210, 220, 304);
a base region (104, 314) located between the sidewall protection region (120, 312) and the trench (122, 200, 210, 220, 304);
a thick oxide layer (130, 316) disposed on the bottom (122b, 200b, 210b, 220b, 304b) of the trench (122, 200, 210, 220, 304);
a gate oxide layer (132, 318) disposed on an inner sidewall (122s, 304s) of the trench (122, 200, 210, 220, 304);
a plurality of separated gates (134, 320) disposed on the inner sidewall (122s, 304s) of the trench (122, 200, 210, 220, 304); and
an insulating material layer (136, 322) disposed in the trench (122, 200, 210, 220, 304) and covering the gates (134, 320).

9. The silicon carbide trench MOSFET according to claim 8, wherein the epitaxial layer (102) is an N-type epitaxial layer, and the base region (104, 314) is a P-type base region.

10. The silicon carbide trench MOSFET according to claim 9, wherein the first conductive type heavily-doped region (106, 308) is an N+ region, and the second conductive type heavily-doped region (108, 310) is a P+ region.

11. The silicon carbide trench MOSFET according to claim 9, wherein the sidewall protection region (120, 312) is a P-type region, and the bottom protection region (128, 306) is a P-type region.

12. The silicon carbide trench MOSFET according to claim 8, wherein a doping concentration of the bottom protection region (128, 306) gradually becomes lighter from a top center outward.

13. The silicon carbide trench MOSFET according to claim 8, wherein the bottom (122b, 200b, 210b, 220b, 304b) of the trench (122, 200, 210, 220, 304) is full rounding or partial rounding.

14. The silicon carbide trench MOSFET according to claim 8, wherein the rounded corner (CR) of the trench (122, 200, 210, 220, 304) has a radius of curvature of 0.3 µm to 1.5 µm.

15. A silicon carbide trench MOSFET, comprising:
a substrate (100);
an epitaxial layer (102) disposed on the substrate (100);
a trench (122, 200, 210, 220, 304) extending from a surface (102s, 302s) of the epitaxial layer (102) towards the substrate (100), wherein a bottom (122b, 200b, 210b, 220b, 304b) of the trench (122, 200, 210, 220, 304) has a rounded corner (CR);
a bottom protection region (128, 306) located below the bottom (122b, 200b, 210b, 220b, 304b) of the trench (122, 200, 210, 220, 304), wherein the bottom protection region (128, 306) has a profile that is wide at a top and narrow at a bottom (122b, 200b, 210b, 220b, 304b), and a doping concentration of the bottom protection region (128, 306) gradually becomes lighter from a top center outward;
a first conductive type heavily-doped region (106, 308) located on the surface (102s, 302s) of the epitaxial layer (102) and on both sides of the trench (122, 200, 210, 220, 304);
a second conductive type heavily-doped region (108, 310) located on the surface (102s, 302s) of the epitaxial layer (102) and on a side of the first conductive type heavily-doped region (106, 308) away from the trench (122, 200, 210, 220, 304);
a sidewall protection region (120, 312) located below the second conductive type heavily-doped region (108, 310) in the epitaxial layer (102);
a base region (104, 314) located between the sidewall protection region (120, 312) and the trench (122, 200, 210, 220, 304);
a thick oxide layer (130, 316) disposed on the bottom (122b, 200b, 210b, 220b, 304b) of the trench (122, 200, 210, 220, 304);
a gate oxide layer (132, 318) disposed on an inner sidewall (122s, 304s) of the trench (122, 200, 210, 220, 304);
a plurality of separated gates (134, 320) disposed on the inner sidewall (122s, 304s) of the trench (122, 200, 210, 220, 304); and
an insulating material layer (136, 322) disposed in the trench (122, 200, 210, 220, 304) and covering the gates (134, 320).

16. The silicon carbide trench MOSFET according to claim 15, wherein the epitaxial layer (102) is an N-type epitaxial layer, and the base region (104, 314) is a P-type base region.

17. The silicon carbide trench MOSFET according to claim 16, wherein the sidewall protection region (120, 312) is a P-type region, and has a doping concentration that gradually becomes lighter from the surface (102s, 302s) downward.

18. The silicon carbide trench MOSFET according to claim 16, wherein the bottom protection region (128, 306) is a P-type region.

19. The silicon carbide trench MOSFET according to claim 15, wherein the bottom (122b, 200b, 210b, 220b, 304b) of the trench (122, 200, 210, 220, 304) is full rounding or partial rounding.

20. The silicon carbide trench MOSFET according to claim 15, wherein the rounded corner (CR) of the trench (122, 200, 210, 220, 304) has a radius of curvature of 0.3 µm to 1.5 µm.
